# EUROPÄISCHE PATENTANMELDUNG

(11) **EP 1 314 801 A1**
(43) Veröffentlichungstag der Anmeldung: **28.05.2003**
(21) Anmeldenummer: 01250416.3
(22) Anmeldetag: 27.11.2001
(51) Int. Cl.: C30B 29/62, C30B 1/00, C30B 11/12

(54) **Verfahren zum Züchten fadenformiger Kristalle und Vorrichtung zur Durchführung des Verfahrens**

(71) Anmelder: Finpar Holding S.A., 2014 Luxemburg (LU)
(72) Erfinder: Titov, Alexandr Alexandrovitsch, 109652 Moskau (RU); Ljapin, Gennadij Sergeevitsch, 113186 Moskau (RU)
(74) Vertreter: Neumann, Günter

(57) **Zusammenfassung**

Die Erfindung betrifft ein Verfahren und eine Vorrichtung zum Züchten fadenförmiger Kristalle. Sie ist dadurch gekennzeichnet, dass fadenförmige Kristalle (9) auf einem Plattenwerkstoff (3') in einer mit Arbeitsgas gefüllten Kammer (1) im Wirkungsfeld entgegengerichteten Diffraktionsfelder von Röntgenstrahlern (7) gezüchtet werden, wobei deren Strahlung im Innenraum (2) der Kammer (1) durch ein Paket von an den Stirnseiten der Kammer (1) angebrachten Platten (3;3') gerichtet ist und innerhalb des Plattenpaketes (3;3') ein isoliertes Heizelement (4) angeordnet ist.

Der Vorzug der Erfindungen besteht darin, dass ohne Impfkristalle und bei wesentlich niedrigeren Kosten und deutlich höherer Produktivität gegenüber bekannten Verfahren Kristalle mit neuen physikalischen Eigenschaften gezüchtet werden können. Mit den Kristalle können beispielsweise Halbleiter-Bauelemente gefertigt werden, die für einen Einsatz in der Kernkraftindustrie, der Weltraumtechnik und der Flugzeugindustrie etc. geeignet sind, da Bauelemente mit den genannten Kristallen bei sehr hohen Temperaturen sowie hohen Kern- und anderen Strahlungspegeln operieren können

## Beschreibung

Die Erfindung betrifft ein Verfahren zum Züchten fadenförmiger Kristalle und eine Vorrichtung zur Durchführung des Verfahrens. Die Erfindungen sind insbesondere zur Anwendung in der Halbleiterindustrie geeignet.

Verfahren und Vorrichtungen zum Züchten von Kristallen und Diamantepitaxieschichten sind bereits bekannt.
So wird in der RU 2131951 C1 ein Verfahren zur Gewinnung fadenförmiger Zinkoxid-Kristalle beschrieben, bei dem die Züchtung der fadenförmigen Zinkoxid-Kristalle unter Luft durch Nutzung eines kontinuierlich strahlenden CO₂-Lasers erfolgt.
Die Erfindung ermöglicht die Herstellung fadenförmiger Kristalle ohne Impfkristalle und ohne Impfkristallisationskammern. Bei Versuchen zur Anwendung der Erfindung wurde ein serienmäßiger, kontinuierlich strahlender CO₂-Laser LG-25 mit 25 W Leistung verwendet. Bei Fokussierung mit einer C-Linse mit einem Brennpunkt f von 20 cm überstieg die Leistungsdichte auf der Tablettenoberfläche 10⁵ W/cm².

Zu den Nachteilen dieses Verfahrens zählen die aufwendigen vorbereitenden Vorgänge, da zuerst Tabletten aus Zinkoxid-Pulver OCTCH mit den Abmessungen L = 1 cm und D = 1 cm vorgepresst und dann in einem Muffelofen bei T = 800°C für 1 Stunde geglüht werden müssen. Die Bestrahlung dauerte 1 Minute bis 3 Minuten. Daraus folgt, dass der ganze Vorgang über eine Stunde dauerte.

Aufgabe der Erfindung ist es daher, ein verbessertes, weniger aufwendiges Verfahren zur Herstellung fadenförmiger Kristalle und eine Vorrichtung zur Durchführung des Verfahrens bereitzustellen.

Erfindungsgemäß wird die Aufgabe durch ein Verfahren mit den Merkmalen des Anspruches 1 gelöst. Vorteilhafte Ausgestaltungen des Verfahrens ergeben sich aus den Merkmalen der Ansprüche 2 bis 5.
Des weiteren wird die Aufgabe durch eine Vorrichtung mit den Merkmalen des Anspruches 6 gelöst. Bevorzugte Ausgestaltungen der Vorrichtung ergeben sich aus den Merkmalen der Ansprüche 7 bis 9.

Das Verfahren zum Züchten fadenförmiger Kristalle ist dadurch gekennzeichnet, dass das Kristallwachstum auf einem plattenförmigen Werkstoff erfolgt, der in einer mit Arbeitsgas gefüllten Kammer im Wirkungsfeld entgegengerichteter Diffraktionsfelder von Röntgenstrahlern angeordnet ist. Deren Strahlung gelangt in die Kammer durch ein Paket von an den Stirnseiten der Kammer angebrachten Platten. Innerhalb des Plattenpakets sind Spiralen eines isolierten Heizelements angeordnet.

Das erfindungsgemäße Verfahren erlaubt es, das Material der Platten und die Gase auszuwählen. So ist es mit dem Verfahren möglich, Kristalle aus Molybdän, Tantal, Kupfer, Silber und Niob zu züchten. Es hat dadurch ein breites Anwendungsgebiet. Durch die Möglichkeit der Steuerung der räumlichen Diffraktion im Arbeitsgas können unter Berücksichtigung der Materialeigenschaften Quasikristalle mit verschiedenen Symmetrieachsen gezüchtet werden.
Der besondere Vorzug des erfindungsgemäßen Verfahrens besteht darin, dass bei wesentlich niedrigeren Kosten und deutlich höherer Produktivität gegenüber bekannten Verfahren Kristalle mit neuen physikalischen Eigenschaften gezüchtet werden können. In Versuchen betrug die Zeit für das Züchten der Kristalle einschließlich aller vorbereitenden Operationen nur 15 Minuten bis 20 Minuten.

Von bekannten Verfahren zum Züchten von Kristallen unterscheidet sich das erfindungsgemäße Verfahren insbesondere dadurch, dass es ohne Impfkristalle auskommt und dass in allen technologischen Schritten die Wellen- und Quantenmechanik wirkt. Im Vergleich zu bekannten technischen Lösungen zeichnet sich das erfindungsgemäße Verfahren insbesondere durch entgegengesetzte Diffraktionsfelder der Röntgenstrahlung aus.
Das erfindungsgemäße Verfahren für die Gewinnung von fadenförmigen Kristallen aus Metallschichtträgern unter Einsatz der sogenannten Beugungsverdampfungskristallisationsmethode gestattet es, Kristalle nicht nur mit bestimmten Eigenschaften zu züchten, sondern auch die physikalischchemischen Eigenschaften des Metallschichtträgers so zu verändern, dass die Bedingungen für die Supraleitfähigkeit und die magnetische Sättigung erweitert werden.

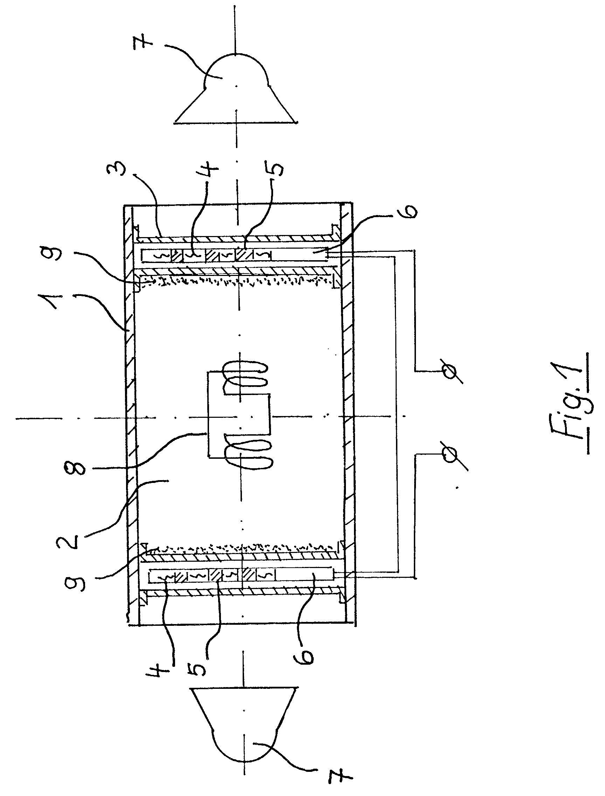

Im folgenden sollen die Erfindungen an Hand einer Figur näher erläutert werden. Figur 1 zeigt schematisch die Anordnung einer Vorrichtung zur Anwendung des erfindungsgemäßen Verfahrens.

Wie aus Fig. 1 ersichtlich ist, besteht die Vorrichtung aus einer Kammer 1, deren Gehäuse aus Glas oder keramischem Material ausgeführt ist. Die Kammer 1 ist in ihrem Innenraum 2 mit Arbeitsgas gefüllt. An den Stirnseiten der Kammer 1 sind Plattenpakete 3 und 3' angeordnet. Zwischen den Platten 3 und 3' befindet sich die Heizspirale 4 mit keramischen Isolatoren 5, die zusammen das Heizelement 6 bilden. Die Heizspirale 4 ist auf der gesamten Oberfläche der Platten 3 angeordnet, wodurch eine gleichmäßige Erwärmung der Platten 3 gewährleistet ist. Außerhalb der Stirnseiten der Kammer 1 sind die Röntgenstrahler 7 (zum Beispiel vom Typ Arina-3) angeordnet. Sie bestrahlen die gesamte Oberfläche der Platten 3. Vorzugsweise ist innerhalb der Kammer 1 auf deren Achse eine Spule 8 (eine kurzgeschlossene Spirale aus Windungen, welche bezüglich dem Mittelpunkt der Kammer 1 auseinandergezogen sind) angeordnet. Mit der Anordnung der Spule 8 verbindet sich der Vorzug einer optimalen Ausrichtung der Röntgenstrahlen auf die Platten 3', wodurch eine gleichmäßige Beschichtung der Platten 3' und ein gleichmäßiges Wachstum der fadenförmigen Kristalle gefördert werden.
Die Heizspirale 4 ist an das gewöhnliche Wechselstromnetz angeschlossen und sichert eine Erwärmung der Platten 3 und 3' bis zu einer Temperatur von 1000°C bis 2000°C und eine Erwärmung des Arbeitsgasmediums bis zu einer Temperatur von 400°C bis 500°C. Im vorliegenden Beispiel wird als Gasmedium 2 Luft unter atmosphärischem Druck verwendet. Dabei sind im Ausführungsbeispiel als Platten 3' solche aus Tantal eingesetzt, an deren dem Mittelpunkt der Kammer 1 zugewandten Innenfläche erfindungsgemäß eine die ganze Fläche der Platten gleichmäßig bedeckende Schicht der Kristalle 9 gebildet wird. Die Platten 3 sind aus gewöhnlichem Stahl gefertigt.
Die Abmessungen der im Beispiel verwendeten Kammer 1 betragen L = 400 mm und D = 160 mm. Der Durchmesser der Platten 3 und 3' beträgt 150 mm.
Das Bedienungspersonal ist durch hier nicht dargestellte Vorkehrungen vor Röntgenstrahlen geschützt.

Nach Einschalten der Heizelemente 6 werden die Platten 3 und 3' erhitzt, die ihrerseits das im Kammerinnenraum 2 befindliche Arbeitsgas auf die erforderliche Arbeitstemperatur erwärmen. Danach werden die Röntgenstrahler 7 in Betrieb genommen. Nach 4 Minuten bis 5 Minuten bilden sich auf den Innenseiten der Platten 3' an der dem Mittelpunkt der Kammer 1 zugewandten Seite die ganze Plattenfläche bedeckende Kristallstrukturen.

Auf der Basis der erfindungsgemäß gezüchteten Kristalle können Halbleiter-Bauelemente (Transistoren, integrierte Schaltungen - IC -, Dioden usw.) gefertigt werden, die insbesondere für einen Einsatz in der Kernkraftindustrie, der Weltraumtechnik und in der Flugzeugindustrie etc. geeignet sind, da diese Bauelemente mit den genannten Kristallen bei sehr hohen Temperaturen sowie hohen Kern- und anderen Strahlungspegeln operieren können. Die letzt genannte Eigenschaft ist bekanntlich ein sehr wichtiger Faktor in der modernen Elektronik.

Es ist des weiteren möglich, diese Kristalle für die Entwicklung einer neuen Klasse von elektronischen Bauelementen zu nutzen, so für photoelektronische Bauelemente (Phototransistoren, Photothyristoren, Photodioden und für andere optoelektronische Komponenten) sowie für aktive Elemente von Sonnenbatterien.

Eine weitere Anwendungsmöglichkeit von Bauelementen mit erfindungsgemäßen fadenförmigen Kristallen sind Computer und Bioroboter der neuen Generation, da der Querschnitt der Kristalle nur einige Mikron beträgt.

### BEZUGSZEICHENAUFSTELLUNG

- 1: Kammer
- 2: Kammerinnenraum
- 3: Platte
- 3': Platte
- 4: Heizspirale
- 5: Isolator
- 6: Heizelement
- 7: Röntgenstrahler
- 8: Spule
- 9: Kristalle

## Patentansprüche

1. Verfahren zum Züchten fadenförmiger Kristalle, **dadurch gekennzeichnet, dass** die fadenförmigen Kristalle (9) auf einem Plattenwerkstoff (3') in einer mit Arbeitsgas gefüllten Kammer (1) im Wirkungsfeld entgegengerichteten Diffraktionsfelder von Röntgenstrahlern (7) gezüchtet werden, wobei deren Strahlung im Innenraum (2) der Kammer (1) durch ein Paket von an den Stirnseiten der Kammer (1) angebrachten Platten (3;3') gerichtet ist und innerhalb des Plattenpaketes (3;3') ein isoliertes Heizelement (4) angeordnet ist.

2. Verfahren nach Anspruch 1, **dadurch gekennzeichnet, dass** die Platten (3;3') auf eine Temperatur von 1000°C bis 2000°C erhitzt werden und die Temperatur des Arbeitsgases 400°C bis 500°C beträgt.

3. Verfahren nach Anspruch 1 oder 2, **dadurch gekennzeichnet, dass** die Platten (3') vorzugsweise aus Molybdän, Tantal, Kupfer, Silber oder Niob bestehen.

4. Verfahren nach einem der Ansprüche 1 bis 3, **dadurch gekennzeichnet, dass** die Röntgenstrahler (7) eine Leistung haben, die mindestens bis auf 10⁵ W/cm² fokussiert werden kann.

5. Verfahren nach einem der Ansprüche 1 bis 4, **dadurch gekennzeichnet, dass** die Strahlung der Röntgenstrahler (7) durch eine auf der Achse der Kammer (1) angeordnete Spule (8) optimal auf die Flächen der Platten (3') ausgerichtet werden und dadurch eine gleichmäßige Beschichtung der Platten (3') und ein gleichmäßiges Wachstum der Kristalle erreicht wird.

6. Vorrichtung zur Durchführung des Verfahrens gemäß den Ansprüchen 1 bis **5 bestehend**
- aus einer Kammer (1),
- aus außerhalb der Stirnseiten der Kammer (1) angeordneten Röntgenstrahlern (7),
- aus an innerhalb der Kammer (1) an deren Stirnseiten angeordneten Plattenpaketen (3;3') mit jeweils innerhalb der Plattenpakete (3;3') angeordneten isolierten Heizelementen (4), wobei die Platte (3') aus dem Werkstoff für die Kristallzüchtung besteht.

7. Vorrichtung nach Anspruch 6, **dadurch gekennzeichnet, dass** das Gehäuse der Kammer (1) aus einem Glas- oder keramischen Werkstoff besteht.

8. Vorrichtung nach Anspruch 6 oder 7, **dadurch gekennzeichnet, dass** innerhalb der Kammer (1) auf deren Achse eine Spule (8), bestehend aus einer kurzgeschlossenen Wicklung, angeordnet ist.

9. Vorrichtung nach einem der Ansprüche 6 bis 8, **dadurch gekennzeichnet, dass** die Röntgenstrahler (7) eine Leistung haben, die mindestens bis auf 10⁵ W/cm² fokussierbar ist.
